# EUROPEAN PATENT SPECIFICATION

(11) **EP 0 517 532 B1**
(45) Date of publication and mention of the grant of the patent: **16.08.1995**
(21) Application number: 92305159.3
(22) Date of filing: 05.06.1992
(51) Int. Cl.: H01S 3/00, H01S 3/108, G02F 2/02

(54) **Optical wavelength shifter**
Optischer Wellenlängenwandler
Translateur de longueur d'onde optique

(30) Priority: 06.06.1991 JP 167370/91
(43) Date of publication of application: 09.12.1992
(73) Proprietor: HAMAMATSU PHOTONICS K.K., Shizuoka-ken (JP)
(72) Inventor: Urakami, Tsuneyuki, c/o Hamamatsu Photonics K.K., Hamamatsu-shi, Shizuoka-ken (JP); Aoshima, Shinichiro, c/o Hamamatsu Photonics K.K., Hamamatsu-shi, Shizuoka-ken (JP)
(74) Representative: Rackham, Stephen Neil

(56) References cited:
- EP-A- 0 301 803
- APPLIED PHYSICS LETTERS, vol. 52, no. 23, 6 June 1988, New York, US, pp. 1939-1941; P.L. BALDECK ET AL. 'Induced frequency shift of copropagating ultrafast optical pulses'

## Description

The present invention relates to an optical wavelength shifter, and more particularly to an optical wavelength shifter for shifting the wavelength of light by varying timings at which the light and a pump pulse are incident on a nonlinear refractive medium.

Intense, ultrafast, and broad-spectral-width pulses close to white-light called continuum or supercontinuum are generated by passing picosecond laser pulses through a nonlinear refractive medium having a nonlinear refractive index.

For spectral broadening, it has been known to utilize a phase modulation wherein the spectral range of the laser is broadened when the laser pulse passes through a nonlinear refractive medium. As the laser pulse passes through the medium, it causes a refractive index change. This in turn induces a phase change which causes a frequency sweep within the pulse envelope. This is called self phase modulation (SPM). Induced phase modulation (IPM) and cross phase modulation (XPM) are also known in the art. In IPM, a phase modulation is performed using an intense laser pulse serving as pump pulse. More specifically, when a weak pulse of a different frequency passes through the medium whose refractive index was changed by the intense laser pulse, the phase of the weak optical field can be modulated by the time variation of the index of refraction originating from the primary intense pulse.

Similarly, in XPM, light is phase shifted when a pump pulse and the light to be modulated are simultaneously incident on the non-linear refractive medium, wherein the phase shift depends on the peak power of the pump pulse. A differential of the phase shift corresponds to a frequency modulation, hence the phase modulation is equivalent to the frequency modulation. Consequently, the spectrum of light can be broadened or an optical wavelength can be changed through the phase modulation by way of XPM. As disclosed in a paper entitled "Induced-frequency shift of copropagating ultrafast optical pulses" by P. L. Baldeck et al, announced in "American Institute of Phys" published June 6, 1988, it has been known that the central wavelength is shifted caused by the change of a timing at which the pump pulse and the light to be modulated are incident on the non-linear refractive medium. Since the phase modulation depends on the peak power of the pump pulse in XPM, there is a problem that a large peak power pump pulse is required.

According to this invention an optical wavelength shifter comprising:
a laser resonator having a first laser mirror, a second laser mirror, a laser medium disposed between said first and second laser mirrors, and exciting means for exciting said laser medium to produce a pump pulse from said laser medium;
a non-linear optical medium having a non-linear refractive index;
light emitting means for emitting light to be modulated; and,
timing delay means disposed to receive the light emitted from said light emitting means and to apply the light into said non-linear optical medium with a required delay;
is characterised in that the non-linear optical medium is disposed inside the laser resonator so that the pump pulse propagating between the laser mirrors is incident on said non-linear optical medium.

Particular embodiments of the present invention will now be described with reference to the accompanying drawings, in which:-
Fig. 1 is a block diagram showing an optical waveform shifter according to a first embodiment of the present invention;
Fig. 2 is a block diagram showing an optical waveform shifter according to a second embodiment of the present invention;
Fig. 3 is a block diagram showing an optical waveform shifter according to a third embodiment of the present invention;
Fig. 4 is a block diagram showing an optical waveform shifter according to a fourth embodiment of the present invention;
Fig. 5 is an explanatory diagram showing a first example of a timing delay unit usable in the embodiments of the present invention;
Fig. 6 is an explanatory diagram showing a second example of the timing delay unit usable in the embodiments of the present invention;
Fig. 7 is an explanatory diagram showing a third example of the timing delay unit usable in the embodiments of the present invention;
Fig. 8 is an explanatory diagram showing a fourth example of the timing delay unit usable in the embodiments of the present invention; and
Fig. 9 is an explanatory diagram showing a fifth example of the timing delay unit usable in the embodiments of the present invention.

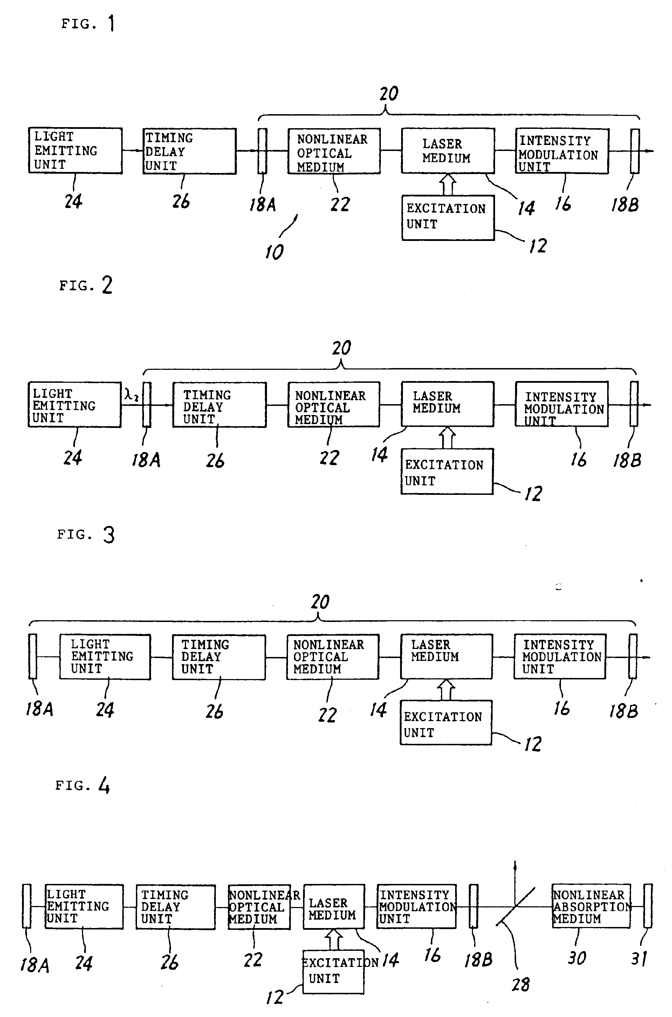

A first embodiment of an optical wavelength shifter 10 is shown in block form in Fig. 1. The wavelength shifter 10 includes a laser resonator 20, a nonlinear optical medium having a nonlinear refractive index, a light emitting unit 24, and a timing delay unit 26. The laser resonator 20 includes an input laser mirror 18A, an output laser mirror 18B, a laser medium 14, and an excitation unit 12 for exciting the laser medium 14. The nonlinear optical medium 22 whose refractive index changes when laser pulses pass therethrough is disposed interiorly of the laser resonator 20. In the embodiment shown in the figure, the nonlinear optical medium 22 is disposed between the input laser mirror 18A and the laser medium 14. An intensity modulation unit 16 may optionally be disposed between the laser medium 14 and the output laser mirror 18B. With such an arrangement, the light emitted from the unit 24 and the pump pulse are incident on the nonlinear optical medium 22 to thereby phase modulate the light. The timing delay unit 26 delays a timing at which the light to be modulated is incident on the nonlinear optical medium 22 to thereby shift the wavelength of the light.

The input and output laser mirrors 18A, 18B have high transmissivity for the wavelength λ2 of the light emitted from the light emitting unit 24 and high reflectivity against the wavelength λ1 of the light oscillated from the laser medium 14.

Laser diode, solid laser, dye laser, or gas laser are usable for the laser resonator 20. The two end faces of the laser diode, when used for the laser resonator 20, needs to be coated with a material having a high transmissivity to the light to be modulated and a small transmissivity to the pump pulse oscillated in the laser resonator 20.

For the excitation unit 12, various kinds of lasers or flash lamps are usable in the case of photo-excitation, a current producing unit is usable in the case of current excitation, and a discharge generation unit is usable in the case of discharge excitation.

Semiconductor, solid, liquid and gaseous materials are usable for the laser medium 14. Typically, semiconductor materials, such as GaAs, InGaAsP, InAlP, solid materials, such as Nd-YAG, YLF, Cr³+:Mg₂SiO₄, Cr⁴+:Mg₂SiO₄, and fibers, liquid materials, such as Rhodamine6G, gaseous materials, such as argon, excimer, CO₂, copper vapor, are usable.

The nonlinear optical medium 22 is selected from the materials having a nonlinear refractive index. Such materials include, for example, hydrogen, water (H₂O, D₂O), acetone, cyclohexanone, nitrogen, oxygen, nitrobenzene, toluene, chlorobenzene, bromobenzene, benzene, CS₂, CCl₄, diamond, calcite, silicon, rock crystal, LiTaO₃, InSb, optical fiber or the like.

The intensity modulation unit 16 can be selected from a Q-switch, cavity dumper, mode locker, and passive mode locking owing to a saturable absorption dye, all of which are well know in the art. For the laser medium 14 made of a semiconductor material, the intensity modulation unit 16 can be dispensed with by using an excitation current pulse.

For the Q-switch constituted with an A/O element or E/O element, the laser medium 14 is excited under the condition where the Q factor is lowered, and then the Q factor is abruptly increased when the population inversion density has become sufficiently large, to thereby obtain an intense, ultrashort duration laser output.

For the cavity dumper used for the intensity modulation unit 16, the laser output is pulsated while instantaneously taking out the energy stored in the interior of the laser resonator 20 through diffraction.

For the mode locker used for the intensity modulation unit 16, an A/O element or E/O element is incorporated in the interior of the laser resonator 20 to forcibly synchronize the phases of a plurality of simultaneously oscillating longitudinal modes using an electrical signal applied from externally.

When the intensity modulation unit 16 is operating in the passive mode locking by the use of an absorbable dye, the absorbable dye absorbs the weak light to thereby further weaken the light but little absorbs the intense light and remains such light substantially the same.

It should be noted that the excitation unit 12 can also be used as the intensity modulation unit 16. Specifically, in the case of light excitation, the excitation unit 12 pulsates the excited light, and in the case of current excitation, the excitation is performed by a pulsating current. A hybrid arrangement in which these excitation means 6 are combined can be adopted.

As the light emitting unit 24, light sources of various kinds of lasers or LEDs can be used.

In operation, since the input and output laser mirrors 18A, 18B have high reflectivity against the wavelength λ1 of light oscillated from the excited laser medium 14, the wavelength λ1 light is resonated between the input and output laser mirrors 18A, 18B and pulse light is produced from the intensity modulating unit 16. On the other hand, the light of wavelength λ2 emitted from the light emitting unit 24 is introduced into the laser resonator 20 through the timing delay unit 26. The light can easily be introduced into the laser resonator 20 and derived from the laser resonator 20, since the input and output laser mirrors 18A, 18B have high transmissivity to the light of wavelength λ2.

The light of wavelength λ2 and the pump pulse of wavelength λ1 are simultaneously incident on the nonlinear optical medium 22, where the light of wavelength λ2 is subjected to phase modulation. The phase modulated light is outputted from the output laser mirror 18B. The timing delay unit 26 delays the incident timing of the light to be modulated, so that the light is undergone the wavelength shift.

P.L. Baldeck et al reported in the paper mentioned previously that about 0.45 nm wavelength shift was observed in an experiment using a laser light whose peak power is 4 kw. In the case of using the pump pulse of the same peak power in the present invention, the peak power contributed to XPM is 100 times as large as the peak power reported in that paper, assuming that the transmissivity of the mirrors of the laser resonator is about 1 %. Therefore, the wavelength can be shifted in a range of 45 nm.

A waveform shifter according to a second embodiment of the present invention is shown in Fig. 2. The second embodiment is similar in arrangement to the first embodiment except that the timing delay unit 26 is disposed between the, input mirror 18A and the nonlinear optical medium 22.

A waveform shifter according to a third embodiment of the present invention is shown in Fig. 3. The third embodiment is also similar to the first embodiment except that both the light emitting unit 24 and the timing delay unit 26 are disposed interiorly of the laser resonator 20. The input laser mirror 18A has a high reflectivity against the light of wavelengths λ1 and λ2. The output mirror 18B, on the other hand, has a high transmissivity to the light of wavelength λ2 and high reflectivity against the light of wavelength λ1.

In the third embodiment, the light emitting unit 26 may be arranged so as to perform waveform conversion of a part of the laser light of wavelength λ2 which has been oscillated in the laser resonator 20 and to produce a light of wavelength λ1 which is an SHG (second harmonic generation) of the light of wavelength λ2. To effect the waveform conversion, ADP,KDP, β-BaBO₄ are available, whereby SHG light, THG (third harmonic generation) light, FHG (fifth harmonic generation) light or parametric oscillation light are obtainable. Hence, in such cases, it is not necessary to actuate the light emitting unit 24 by other means. Further, the power loss of the light to be modulated can be suppressed.

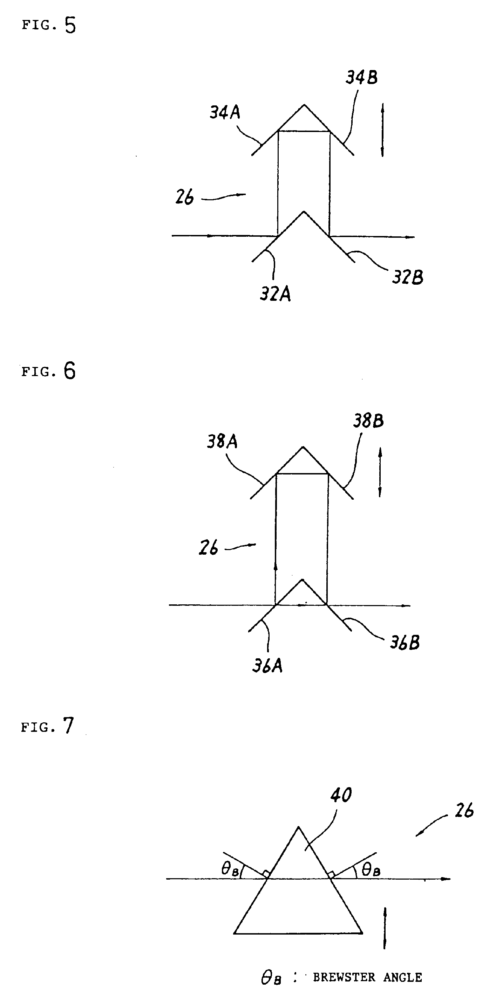

A fourth embodiment of the present invention is shown in Fig. 4. The fourth embodiment is similar to the third embodiment shown in Fig. 3 but is different therefrom in that the fourth embodiment further includes a dichoroic mirror 28, a nonlinear absorption medium 30, and a total reflection mirror 31 disposed in the stated order at the exterior of the output laser mirror 18B. The dichroic mirror 28 has a high reflectivity against the light of wavelength λ2, whereby the light reflected from the dichroic mirror 28 can be derived as the output light. The transmissivity of the output laser mirror 18B for the light of wavelength λ1 has been set to large. The pump light is subjected to intensity modulation through additive mode-lock by the nonlinear absorption medium 30 and the total reflection mirror 28. The intensity modulation unit can be dispensed with.

The timing delay unit 26 used in the various embodiments has an arrangement shown in Figs. 5 through 7. In the cases where the light emitting unit 24 is disposed exteriorly of the laser resonator 20 as in the first and second embodiments shown in Figs. 1 and 2, the timing delay unit 26 can be arranged as shown in Fig. 5. A pair of mirrors 32A, 32B are arranged at ±45° with respect to an optical axis, and another pair of mirrors 34A, 34B which are in parallel to the mirrors 32A, 32B are movably disposed toward and away from the mirrors 32A, 32B in the direction perpendicular to the optical axis while keeping the parallelism of the two pairs of the mirrors. By the movement of the mirrors 34A, 34B, the optical path length is changed to thus yield a delay of light. A material having a high refractive index such as glass may be provided in the optical path or the length of an optical fiber arranged on the optical axis may be changed.

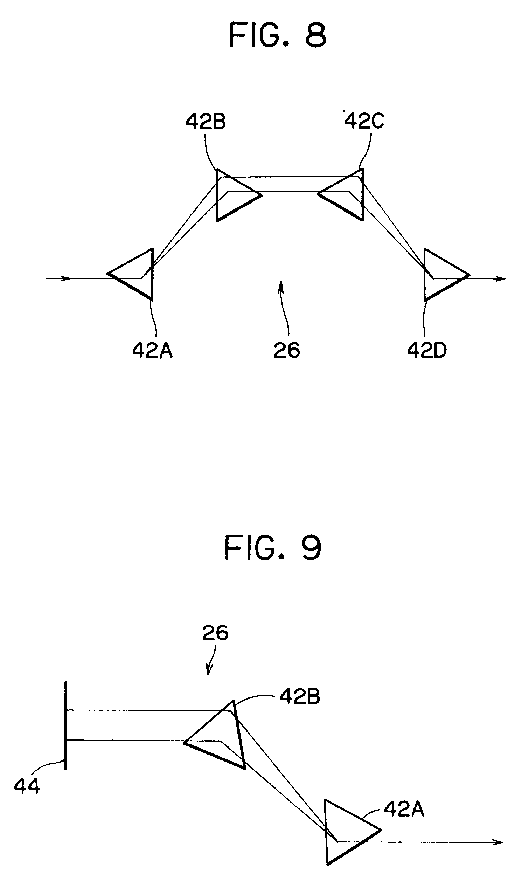

For the cases where the light emitting unit 24 is disposed interiorly of the laser resonator 20 as in the embodiments shown in Figs. 3 and 4, the timing delay unit 26 may be arranged as shown in Fig. 6. In the figure, a pair of, dichroic mirrors 36A, 36B are arranged at ±45° with respect to the optical axis, which are transmissive of the light of wavelength of λ1 and reflective of the light of wavelength λ2 or vice versa. A pair of mirrors 38A, 38B arranged in parallel to the dichroic mirrors 36A, 36B are movably disposed toward and away from the dichroic mirrors 36A, 36B.

As a further example of the timing delay unit 26, a medium 40 having different refractive indices with respect to lights of wavelengths λ1 and λ2 may be movably disposed in the laser resonator 20. The effective optical path lengths of the lights of λ1 and λ2 can be changed with the use of prisms 42A, 42B, 42C and 42D arranged as shown in Fig. 8 or with the use of prisms 42A, 42B and a mirror 44 arranged as shown in Fig. 9. By moving the positions of the prisms 42B and 42C, the optical path lengths of the lights passing through the medium, i.e., prism, are changed to thereby differentiate the optical path lengths.

In the embodiments described, by the provision of a correction arrangement such as grating pair for correcting a phase dispersion on each wavelength in the interior of the laser resonator 20 or to the laser medium 14, the light to be modulated can be formed into short pulses and a pulse width varying function can be achieved.

Although the laser medium 14 and the nonlinear optical medium 22 are separately provided, the nonlinear medium 22 is not required if the laser medium 14 has a nonlinear refractive index.

The intensity of light within the laser resonator is greater by one or two orders than the intensity of light, extracted out of the laser resonator, so that a high peak power pump pulse can be incident on the nonlinear optical medium. Thus, the wavelength shift can be correspondingly increased, since the wavelength shift depends on the peak power of the pump pulse.

## Claims

1. An optical wavelength shifter (10) comprising:
a laser resonator (20) having a first laser mirror (18A), a second laser mirror (18B), a laser medium (14) disposed between said first and second laser mirrors (18), and exciting means (12) for exciting said laser medium (14) to produce a pump pulse from said laser medium (14);
a non-linear optical medium (22) having a non-linear refractive index;
light emitting means (24) for emitting light to be modulated; and,
timing delay means (26) disposed to receive the light emitted from said light emitting means (24) and to apply the light into said non-linear optical medium (22) with a required delay;
characterised in that the non-linear optical medium is disposed inside the laser resonator (20) so that the pump pulse propagating between the laser mirrors (18) is incident on said non-linear optical medium (22).

2. An optical wavelength shifter according to claim 1, wherein said non-linear optical medium (22) is disposed between said first laser mirror (18A) and said laser medium (14).

3. An optical wavelength shifter according to claim 2, wherein said timing delay means (26) is disposed inside the laser resonator (20) to be positioned between said first laser mirror (18A) and said non-linear optical medium (22).

4. An optical wavelength shifter according to claim 1, wherein said timing delay means (26) and said light emitting means (24) are disposed inside the laser resonator (20) and positioned so that said light emitting means (24) and said timing delay means (26) are disposed between said first laser mirror (18A) and said non-linear optical medium (22) in the stated order.

5. An optical wavelength shifter according to claim 4, wherein said light emitting means (24) produces the light by shifting a wavelength of a part of the pump pulse.

6. An optical wavelength shifter according to any one of the preceding claims, further comprising an intensity modulating means (16) disposed inside said laser resonator (20) for intensity modulating the light oscillating in said laser resonator to produce light pulses.

7. An optical wavelength shifter according to claim 6, wherein said intensity modulating means (16) is disposed adjacent said second laser mirror (18B), and further comprising a dichroic mirror (28) disposed outside the laser resonator (20) and adjacent said second laser mirror (18B), a non-linear absorbing medium (30) being disposed next to said dichroic mirror, and a reflecting mirror (31) being disposed next to said non-linear absorbing medium (30).

8. An optical wavelength shifter according to any one of the preceding claims, wherein said timing delay means (26) comprises means for changing an optical path length of the light emitted from said light emitting means (24).

## Patentansprüche

1. Optischer Wellenlängenwandler (10) mit:
einem Laserresonator (20), welcher einen ersten Laserspiegel (18A), einen zweiten Laserspiegel (18B), ein zwischen dem ersten und zweiten Laserspiegel vorgesehenes Lasermedium (14) sowie eine Anregungseinheit (12) zur Anregung des Lasermediums (14) zwecks Erzeugung eines Pumpimpulses seitens des Lasermediums (14) vorsieht;
einem nichtlinearen, optischen Medium (22), welches einen nichtlinearen Brechungsindex aufweist;
einer lichtemittierenden Einheit (24) zum Emittieren von zu modulierendem Licht; und
einer Zeitverzögerungseinheit (26), welche vorgesehen ist, um von der lichtemittierenden Einheit (24) emittiertes Licht zu empfangen und dieses Licht mit einer erforderlichen Verzögerung dem nichtlinearen, optischen Medium (22) zuzuführen;
dadurch gekennzeichnet, daß das nichtlineare, optische Medium im Inneren des Laserresonators (20) angeordnet ist, so daß der sich zwischen den Laserspiegeln (18) ausbreitende Pumpimpuls auf das nichtlineare, optische Medium (22) trifft.

2. Optischer Wellenlängenwandler gemäß Anspruch 1, bei welchem das nichtlineare, optische Medium (22) zwischen dem ersten Laserspiegel (18A) und dem Lasermedium (14) angeordnet ist.

3. Optischer Wellenlängenwandler gemäß Anspruch 2, bei welchem die Zeitverzögerungseinheit (26) im Inneren des Laserresonators (20) zwischen dem ersten Laserspiegel (18A) und dem nichtlinearen, optischen Medium (22) angeordnet ist.

4. Optischer Wellenlängenwandler gemäß Anspruch 1, bei welchem sich die Zeitverzögerungseinheit (26) und die lichtemittierende Einheit (24) im Inneren des Laserresonators (20) befinden und so angeordnet sind, daß die lichtemittierende Einheit (24) und die Zeitverzögerungseinheit (26) zwischen dem ersten Laserspiegel (18A) und dem nichtlinearen, optischen Medium (22) in der angegebenen Reihenfolge vorgesehen sind.

5. Optischer Wellenlängenwandler gemäß Anspruch 4, bei welchem die lichtemittierende Einheit (24) das Licht durch Wellenlängenverschiebung eines Teiles des Pumpimpulses erzeugt.

6. Optischer Wellenlängenwandler gemäß einem der vörangegangenen Ansprüche, welcher ferner eine, im Inneren des Laserresonators (20) vorgesehene Intensitätsmodulationseinheit (16) zur Intensitätsmodulation des in dem Laserresonator oszillierenden Lichtes zwecks Erzeugung von Lichtimpulsen aufweist.

7. Optischer Wellenlängenwandler gemäß Anspruch 6, bei welchem die Intensitätsmodulationseinheit (16) in Angrenzung an den zweiten Laserspiegel (18B) vorgesehen ist, und welcher ferner einen, außerhalb des Laserresonators (20) und in Angrenzung an den zweiten Laserspiegel (18B) angeordneten Kaltlichtspiegel (28), ein, neben dem Kaltlichtspiegel angeordnetes, nichtlineares Absorptionsmittel (30) sowie einen, neben dem nichtlinearen Absorptionsmittel (30) vorgesehenen Reflexionsspiegel (31) aufweist.

8. Optischer Wellenlängenwandler gemäß einem der vorangegangenen Ansprüche, bei welchem die Zeitverzögerungseinheit (26) Mittel zur Änderung der optischen Weglänge des seitens der lichtemittierenden Einheit (24) emittierten Lichtes aufweist.

## Revendications

1. Translateur de longueur d'onde optique (10) comprenant :
- un résonateur (20) de laser ayant un premier miroir de laser (18A), un second miroir de laser (18B), un milieu laser (14) disposé entre lesdits premier et second miroirs de laser(18), et des moyens d'excitation (12) pour exciter ledit milieu laser (14) pour produire une impulsion de pompage à partir dudit milieu laser (14);
- un milieu optique non-linéaire (22) ayant un indice de réfraction non-linéaire;
- des moyens d'émission de lumière (24) pour émettre de la lumière qui doit être modulée; et
- des moyens de retard de temps (26) disposés de manière à recevoir la lumière émise par lesdits moyens d'émission de lumière (24) et à appliquer la lumière audit milieu optique non-linéaire (22) avec un retard exigé;
caractérisé en ce que le milieu optique non-linéaire est disposé à l'intérieur du résonateur (20) de laser de sorte que l'impulsion de pompage se propageant entre les miroirs de laser (18) est incidente sur ledit milieu optique non-linéaire (22).

2. Translateur de longueur d'onde optique selon la revendication 1, dans lequel ledit milieu optique non-linéaire (22) est disposé entre ledit premier miroir de laser (18A) et ledit milieu laser (14).

3. Translateur de longueur d'onde optique selon la revendication 2, dans lequel lesdits moyens de retard de temps (26) sont disposés à l'intérieur du résonateur (20) de laser de manière à être positionnés entre ledit premier miroir de laser (18A) et ledit milieu optique non-linéaire (22).

4. Translateur de longueur d'onde optique selon la revendication 1, dans lequel lesdits moyens de retard de temps (26) et lesdits moyens d'émission de lumière (24) sont disposés à l'intérieur du résonateur (20) de laser et sont positionnés de sorte que lesdits moyens d'émission de lumière (24) et lesdits moyens de retard de temps (26) sont disposés entre ledit premier miroir de laser (18A) et ledit milieu optique non-linéaire (22) dans l'ordre énoncé.

5. Translateur de longueur d'onde optique selon la revendication 4, dans lequel lesdits moyens d'émission de lumière (24) produisent la lumière en décalant une longueur d'onde d'une partie de l'impulsion de pompage.

6. Translateur de longueur d'onde optique selon l'une quelconque des revendications précédentes, comprenant en outre des moyens de modulation d'intensité (16) disposés à l'intérieur dudit résonateur (20) de laser pour moduler en intensité la lumière oscillant dans ledit résonateur de laser pour produire des impulsions lumineuses.

7. Translateur de longueur d'onde optique selon la revendication 6, dans lequel lesdits moyens de modulation d'intensité (16) sont disposés de façon contiguë audit second miroir de laser (18B), et comprenant en outre un miroir dichroïque (28) disposé à l'extérieur du résonateur (20) de laser et de façon contiguë audit second miroir de laser (18B), un milieu d'absorption non-linéaire (30) étant disposé à côté dudit miroir dichroïque, et un miroir réfléchissant (31) étant disposé à côté dudit milieu d'absorption non-linéaire (30).

8. Translateur de longueur d'onde optique selon l'une quelconque des revendications précédentes, dans lequel lesdits moyens de retard de temps (26) comprennent des moyens pour changer une longueur de chemin optique de la lumière émise par lesdits moyens d'émission de lumière (24).
